# EUROPÄISCHE PATENTSCHRIFT

(11) **EP 1 119 912 B1**
(45) Veröffentlichungstag und Bekanntmachung des Hinweises auf die Patenterteilung: **29.05.2002**
(21) Anmeldenummer: 99969859.0
(22) Anmeldetag: 15.09.1999
(51) Int. Cl.: H03K 3/57

(54) **PULSGENERATOR ZUM ERZEUGEN EINES SPANNUNGSPULSES UND ZUGEHÖRIGES VERFAHREN**
PULSE GENERATOR FOR GENERATING A VOLTAGE PULSE AND CORRESPONDING METHOD
GENERATEUR D'IMPULSIONS DESTINE A PRODUIRE UNE IMPULSION DE TENSION ET PROCEDE CORRESPONDANT

(30) Priorität: 29.09.1998 DE 19844619
(43) Veröffentlichungstag der Anmeldung: 01.08.2001
(73) Patentinhaber: SIEMENS AKTIENGESELLSCHAFT, 80333 München (DE)
(72) Erfinder: HARTMANN, Werner, D-91091 Grossenseebach (DE)
(86) Internationale Anmeldenummer: DE9902952
(87) Internationale Veröffentlichungsnummer: WO0019609

(56) Entgegenhaltungen:
- EP-A- 0 417 771
- EP-A- 0 639 885
- EP-A- 0 789 445
- DE-A- 4 104 386
- GB-A- 1 581 763
- US-A- 4 698 719
- DINELLI G ET AL: "PULSE POWER ELECTROSTATIC TECHNOLOGIES FOR THE CONTROL OF FLUE GAS EMISSIONS" JOURNAL OF ELECTROSTATICS,NL,ELSEVIER SCIENCE PUBLISHERS B.V. AMSTERDAM, Bd. 25, Nr. 1, 1. Juni 1990 (1990-06-01), Seiten 23-40, XP000148330 ISSN: 0304-3886

## Beschreibung

Pulsgenerator zum Erzeugen eines Spannungspulses und zugehöriges Verfahren

Die Erfindung bezieht sich auf einen Pulsgenerator zum Erzeugen eines Spannungspulses für eine im wesentlichen kapazitive Last zur Verwendung bei einem elektrostatischen Staubabscheider. Daneben bezieht sich die Erfindung auch-auf ein Verfahren zum Erzeugen eines Spannungspulses.

Zur Staubrückhaltung in fossil befeuerten Kraftwerken sowie bei zahlreichen anderen industriellen Prozessen wie beispielsweise in der Papier-, Zement- und metallverarbeitenden Industrie werden elektrostatische Staubabscheider (Elektrofilter) eingesetzt, in denen der in einem Gasstrom befindliche Staubanteil durch ein starkes elektrisches Feld aufgeladen, zu einer Elektrode transportiert und dort abgeschieden wird. Abhängig von Leitfähigkeit und Größenverteilung der Staubpartikel treten dabei vorwiegend zwei Probleme auf:
i) Feine Staubanteile werden oft schlechter abgeschieden als grobe; dadurch werden zukünftig entweder aufwendige nachgeschaltete mechanische Filter notwendig, oder bestehende Filteranlagen müssen entsprechend nachgerüstet werden, um den steigenden gesetzlichen Anforderungen bezüglich der Staubimmissionsgrenzwerte zu genügen.
ii) Durch elektrostatische Aufladung der bereits abgeschiedenen Staubschichten kommt es häufig zu Überschlägen, bei denen ein Teil des abgeschiedenen Staubes wieder freigesetzt wird; dadurch kann die Effizienz eines Elektrofilters beträchtlich absinken.

Zur Vermeidung der vorstehend genannten Probleme ist es beispielsweise aus der DE 196 14 195 C1 bekannt, elektrostatische Staubabscheider zu verwenden, denen zur Erhöhung der elektrischen Feldstärke elektrische Hochleistungsimpulse aufgeprägt werden. Dadurch wird sowohl der Abscheidungsgrad speziell für Feinstäube erhöht als auch die Aufladung der abgeschiedenen Staubschichten im Filter herabgesetzt. Aufgrund technischer Grenzen bei der Erzeugung der notwendigen elektrischen Hochleistungsimpulse wurden bisher vergleichsweise lange Impulsdauern von über 50 µs bis zu einigen Millisekunden eingesetzt, die mit ausreichender Lebensdauer mit Hilfe von derzeit erhältlichen kommerziellen Leistungshalbleitern erzeugt werden können.

Aus J. Miller, A. Schwab, "Feinstaubabschaltung in betriebsoptimierten Elektrofiltern", Forschungsbericht FZKA-PEF 140, Universität Karlsruhe 1966, ist es außerdem bekannt, daß die optimale Impulsdauer zur Anwendung dieser Methode abhängig von der Bauart des Staubabscheiders unter 10 µs bei Spannungsamplituden von einigen 10 kV bis zu 100 kV liegt. Die dabei zu schaltenden Impulsströme betragen einige Kiloampere. Bisher existieren jedoch noch keine standardmäßigen, kommerziell angebotenen Bauelemente, mit denen solche Impulse mit der notwendigen Lebensdauer von bis zu 10 Milliarden Impulsen entsprechend einer störungsfreien Betriebsdauer von 1 Jahr bei einer Pulswiederholrate von 300 Hz erzeugt werden können.

In der DE 196 14 195 C1 wird deshalb vorgeschlagen, eine Kombination von langlebigen, jedoch vergleichsweise gering belasteten Halbleiterbauelementen mit nachfolgender Impulskompression durch einen magnetischen Schalter einzusetzen. Der magnetische Schalter ist hierzu in Reihe mit einem Thyristorschalter geschaltet, wobei zur Energiespeicherung und Impulsformung mindestens zwei Hochspannungs-Impulskondensatoren verwendet werden. Als wesentliche Probleme bei diesem Schaltungskonzept ergeben sich die hohe Betriebsspannung von bis zu 60 kV für den Thyristorschalter sowie die notwendige Entwärmung und möglicherweise begrenzte Lebensdauer des magnetischen Schalters. Problematisch ist zudem die Verwendung von Widerständen, die zu einem erheblichen Maß zur Verlustleistung des Gesamtsystems beitragen, da nur ein Teil der in der kapazitiven Last gespeicherten Energie zurückgewonnen werden kann.

In Journal of Electrostatics, 25 (1990), S. 23 bis 40 werden die elektrostatischen Grundlagen für Pulsgeneratoren beschrieben. Insbesondere wird dort ausgeführt, daß üblicherweise ein Resonanzkreis verwendet wird, und daß entweder hohe Spannungspulse direkt erzeugt werden oder aber niedrige Spannungen mittels eines Transformators in hohe Spannungen umgewandelt werden. Weiterhin ist aus der DE 41 04 386 A1 speziell ein Impulsgenerator zur Verwendung in Elektrozaungeräten beschrieben, bei dem ein Impulstransformator verwendet wird.

Schließlich ist aus der GB 1 581 763 A eine Pulsspannungsquelle zur Anwendung eines Spannungspulses an eine kapazitive Last bekannt, die eine Gleichspannungsquelle und einen aufladbaren Kondensator enthält, der mit der Gleichspannungsquelle verbunden ist. Über entsprechende Schaltungsmittel kann eine Pulsspannung vorgegebener Höhe und vorgegebener Pause erzeugt werden. In dieser Druckschrift wird zur Entkopplung der Gleichspannung an der Last von der Pulsspannungsquelle ein zur Pulsspannungsquelle in Reihe geschaltetes zweites Hochspannungsgerät eingesetzt, durch das der gesamte Impulsstrom während der Erzeugung des Hochspannungsimpulses fliesst. Die Beherrschung des Impulsstroms im lastseitigen Hochspannungsgerätes sowie die Tatsache, dass die Pulsspannungsquelle auf Hochspannungspotential liegt, stellen zusätzliche technische Anforderungen dar und sind technisch nur mit erheblichem Aufwand zu erfüllen.

Ausgehend vom Stand der Technik liegt der Erfindung die Aufgabe zugrunde, einen Pulsgenerator zur Erzeugung eines Spannungspulses anzugeben, der die vorstehend genannten Nachteile vermeidet und ohne wesentliche Veränderung bestehender Anlagen deren Wirkungsgrad verbessert. Außerdem liegt der Erfindung die Aufgabe zugrunde ein Verfahren zum Erzeugen eines Spannungspulses anzugeben.

Gemäß der Erfindung wird die erstgenannte Aufgabe mit den Merkmalen des Vorrichtungshauptanspruches 1 und die zweitgenannte Aufgabe mit den Merkmalen des verfahrenshauptanspruches 11 gelöst. Weiterbildungen sind in den jeweils abhängigen Ansprüchen angegeben.

Bei der Erfindung enthält der Pulsgenerator einen Speicherkondensator, der in Reihe mit einem im Nulldurchgang des zur Last fließenden Stromes selbstöffnenden steuerbaren Schalter in einen Serienschwingkreis geschaltet ist, bei dem parallel zum Schalter ein Gleichrichter zum Führen des zur Last in umgekehrter Richtung nach dem Nulldurchgang fließenden Stromes geschaltet ist, wobei bei im wesentlichen kapazitiver Last die Kapazität des Speicherkondensators größer als die Kapazität der Last ist und wenigstens das Zehnfache der Kapazität der Last beträgt und bei dem wenigstens ein erstes Gleichspannungsnetzteil zum Laden des Speicherkondensators vorhanden ist.

Mit der Erfindung wird insbesondere eine solche Anordnung definiert, bei der
- ein transformatorloser Pulsgenerator gebildet ist,
- die Amplitude des Ausgangspulses größer ist als die Spannung des Speicherkondensators,
- die Freiwerdezeit des Schalters (U) kleiner ist als die Stromflußdauer in einer Stromhalbwelle,
- ein parallel zum Schalter geschalteter Gleichrichter zum Führen des zur Last in umgekehrter Richtung nach dem Nulldurchgang fließenden Stromes vorhanden ist,
- die Speicherladung des Gleichrichters klein ist im Vergleich zur Ladung, die während der ersten Stromhalbwelle zur Last transferiert wird, und
- der Strom durch Schaltelement und Gleichrichter im wesentlichen gleich dem Strom in der Last ist.

Bei dem Verfahren gemäß Patentanspruch 11 wird ein in einen Serienschwingkreis geschalteter Speicherkondensator durch Schließen und Öffnen eines steuerbaren Schalters in einem einmaligen Entladevorgang während nur einer halben Schwingungsperiode des Serienschwingkreises auf die Last entladen und in einer zweiten, geringfügig kleineren Stromhalbwelle von der in der Last zwischengespeicherten Energie wieder aufgeladen.

Durch die Maßnahmen gemäß Patentanspruch 1 bzw. 11 können kurze Hochspannungsimpulse von einigen 10 kV Amplitude und Pulsdauern von wenigen Mikrosekunden mit hoher Pulswiederholrate von einigen 100 Hz mit elektrischen Bauelementen erzeugt werden, die problemlos kommerziell bereits verfügbar sind, und bei der weder ein in seiner Lebensdauer und Verlustleistung begrenzter magnetischer Schalter noch verlustbehaftete Widerstände erforderlich sind.

Ein solcher erfindungsgemäßer Pulsgenerator bzw. ein solches erfindungsgemäßes Verfahren kann auch bei der Reinigung von Kraftwerksabgasen von Schwefel- und Stickoxiden eingesetzt werden. Auch hierfür werden Hochspannungsimpulse von mehreren 10 kV Amplitude, wenigen µs Impulsdauer und Impulsströmen von mehreren kA benötigt. Neuere Arbeiten haben gezeigt, daß bei Verfügbarkeit einer entsprechenden Leistungsimpulstechnik solche Verfahren wirtschaftlich arbeiten, was beispielsweise in G. Dinelli, "An integrated approach for flue gas cleaning by impulse energization techniques", IEE Colloquium on "Current environmental applications of electrostatic precipitation", digest no. 118, p. 6/lff., London, UK 1991 ausgeführt ist.

Außerdem kann der erfindungsgemäße Pulsgenerator bzw. das erfindungsgemäße Verfahren bei entsprechender Anpassung der passiven Bauelemente an die geforderten Pulsparameter, auch in anderen Anwendungen eingesetzt werden, wie beispielsweise bei der Pulserzeugung für die Reinigung von Motorabgasen mit Hilfe gepulster Entladungen oder für die Plasmaimmersions-Ionenimplantation.

Da ein im Nulldurchgang des zur Last fließenden Stromes selbstöffnender steuerbarer Schalter vorgesehen ist, wird die zur Steuerung des Schalters erforderliche Steuerelektronik erheblich vereinfacht, da nur das Schließen des Schalters getriggert werden muß.

In einer weiteren bevorzugten Ausgestaltung der Erfindung ist ein parallel zum Schalter geschalteter Gleichrichter zum Führen des zur Last in entgegengesetzter Richtung nach dem Nulldurchgang fließenden Stromes vorgesehen. Dadurch wird die Spannung über der Last schnell abgebaut und die Gesamtpuls dauer begrenzt. Bei einer im wesentlichen kapazitiven Last kann außerdem zumindest ein Teil der auf eine kapazitive Last entladenen Ladung wieder zum Speicherkondensator zurückfließen.

Weitere vorteilhafte Ausgestaltungen der Erfindung ergeben sich gemäß der jeweiligen Unteransprüche.

Zur weiteren Erläuterung der Erfindung wird auf die Ausführungsbeispiele der Zeichnung verwiesen. Es zeigen:
- FIG 1: einen Pulsgenerator gemäß der Erfindung in einem schematischen Schaltbild,
- FIG 2: ein Diagramm, in dem zur Veranschaulichung der Funktionsweise des Pulsgenerators der durch den steuerbaren Schalter fließende Strom, die anliegende Spannung, die Spannung über der Last und der von der Last zum Speicherkondensator zurückführende Strom gegen die Zeit aufgetragen sind,
- FIG 3: ein Ausführungsbeispiel des steuerbaren Schalters mit mehreren in Reihe geschalteten Thyristoren,
- FIG 4: ein Diagramm, in dem die sich in der bevorzugten Betriebsart der Schaltung gemäß FIG 3 ergebenden Spannungen über den Thyristoren gegen die Zeit aufgetragen sind,
- FIG 5: eine weitere vorteilhafte Ausführungsform eines zur Verwendung im Pulsgenerator geeigneten steuerbaren Schalters.

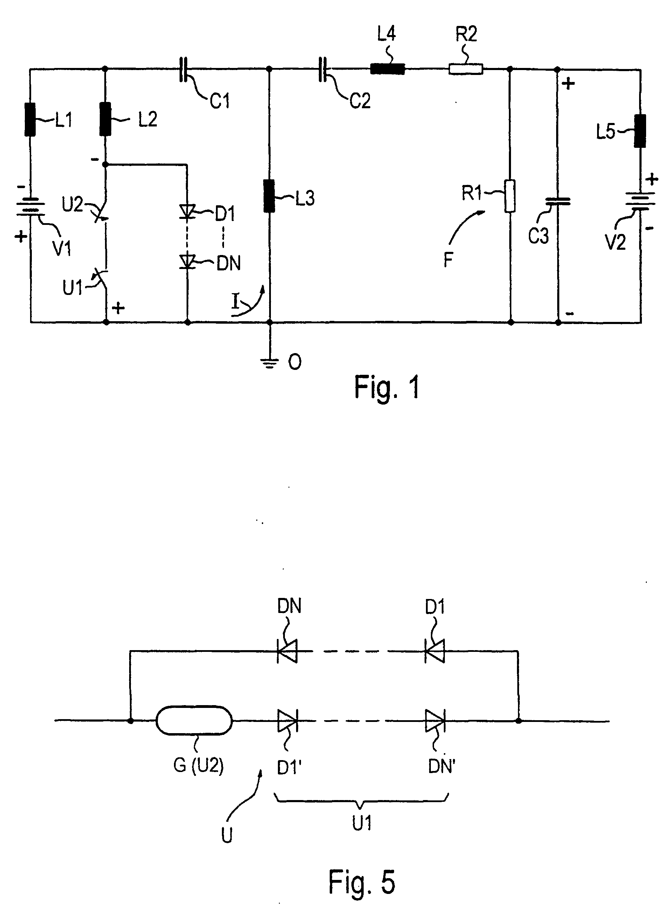

Gemäß FIG 1 enthält der Pulsgenerator einen Serienschwingkreis, der aus einem Speicherkondensator C1 und dazu in Reihe geschaltete Spulen L2 und L4 besteht, die etwa jeweils 10 µH betragen. In den Serienschwingkreis ist in Reihe ein steuerbarer Schalter U geschaltet, der zur Veranschaulichung seiner Funktion symbolisch durch zwei in Reihe geschaltete Teilschalter U1 und U2 dargestellt ist, wobei der Teilschalter U2 ein schließender Schalter und der Teilschalter U1 ein öffnender Schalter ist, wobei beide Funktionen auch in einem einzigen elektronischen Bauteil (Halbleiterventil), beispielsweise ein Thyristor, ein IGBT oder ein GTO, integriert sein können. In der praktischen Ausführungsform ist der Schalter U aus einer Schaltung aufgebaut, die jeweils eine Mehrzahl von steuerbaren Halbleiterventilen enthalten, um die im jeweiligen Anwendungsfall erforderlichen Schaltleistungen zu bewältigen. Der Schalter U kann auch durch einen in Rückwärtsrichtung sperrenden Gasentladungsschalter, beispielsweise ein Thyratron, realisiert werden.

Die Kapazität des Speicherkondensators C1 ist größer als die Kapazität der Last C3. Insbesondere beträgt sie mehr als das Dreifache, vorzugsweise mehr als das Zehnfache der Kapazität der Last C3. Im Ausführungsbeispiel hat der Speicherkondensator C1 eine Kapazität von etwa 1 uF und wird von einem ersten Gleichspannungsnetzteil V1 über Drosseln L1 und L3, deren Induktivität im Ausführungsbeispiel jeweils 40 mH beträgt, auf eine Gleichspannung von etwa 25 kV bis 30 kV aufgeladen. Dabei wird der ausgangsseitige Anschluß des Speicherkondensators C1 über die hochinduktive Drossel L3 während des Ladevorganges auf Erdpotential gehalten.

Ein elektrostatischer Staubabscheider F ist im Ersatzschaltbild der Schaltung elektrisch durch eine kapazitive Last C3 und einen Widerstand R1 charakterisiert, der den Koronastrom durch den Staubabscheider F berücksichtigt. Mit einem zweiten Gleichspannungsnetzteil V2 wird der Staubabscheider F auf typisch etwa 50 kV Hochspannungspotential betrieben.

In die Zuleitung zum elektrostatischen Staubabscheider F ist ein Trennkondensator C2 geschaltet, der die Aufgabe hat, die vom zweiten Gleichspannungsnetzteil V2 erzeugte Grund- oder Filterspannung vom impulserzeugenden ersten Gleichspannungsnetzteil V1 fernzuhalten.

Die Spule L4 und ein in Serie dazu geschalteter Widerstand R2, in der Praxis etwa 0,1 Ω repräsentieren im wesentlichen die Induktivität und den Widerstand der Zuleitung vom Speicherkondensator C1 zum Staubabscheider F.

Die Erzeugung eines Spannungspulses über der kapazitiven Last C3 erfolgt nun durch Schließen des Schalters U, d.h. durch Schließen des Teilschalters U1 bei geschlossenem Teilschalter U2. Dadurch wird die auf negativem Hochspannungspotential aufgeladene Seite des Speicherkondensators C1 auf Massepotential gezogen; aus Ladungserhaltungsgründen wird dadurch der ausgangsseitige oder L3-seitige Anschluß des Speicherkondensators C1 auf ein gleichhohes positives Potential angehoben. Der so erzeugte Ladungsimpuls schwingt über die Elemente L4, C2 und R2 in die kapazitive Last C3 und führt dort zu einer impulsförmigen Spannungserhöhung. Mit anderen Worten: Vom Speicherkondensator C1 fließt nach dem Schließen des Schalters U ein Strom I zur kapazitiven Last C3 und lädt diese auf.

Wenn die Kapazität des Speicherkondensators C1 sehr viel größer als die Kapazität der kapazitiven Last C3 gewählt wird, verdoppelt sich wegen der Erhaltung der Ladung die Amplitude des Spannungsimpulses an der kapazitiven Last C3 annähernd gegenüber der Ladespannung des Speicherkondensators C1, wobei näherungsweise, d.h. ohne Berücksichtigung von Verlusten, die Beziehung U_{C3} = 2*V1*C1/(C1+C3) erfüllt ist.

Im Staubabscheider F wird ein Teil der Ladung des Speicherkondensators C1 in Form einer Koronaentladung zur Aufladung und dem Abtransport von Staub verbraucht. Dies wird im Ersatzschaltbild durch den parallel zur kapazitiven Last C3 geschalteten Widerstand R1 berücksichtigt. Um eine kurze Gesamtpulsdauer an der kapazitiven Last C3 zu erhalten, muß die bei der Koronaentladung nicht verbrauchte Ladung schnell wieder abgebaut werden. Dabei soll die auf der kapazitiven Last C3 verbleibende Ladung möglichst verlustfrei in den Speicherkondensator C1 zurückfließen können, um so die Gesamtverluste insbesondere bei hohen Impulswiederholraten zu minimieren. Dies wird bei Verwendung eines im Stromnulldurchgang selbstöffnenden Schalters U, beispielsweise eine Thyristorschaltung, insbesondere eine Reihenschaltung mehrerer Thyristoren, ermöglicht durch einen antiparallel zum Schalter U geschalteten Gleichrichter, im Beispiel N in Reihe geschaltete schnelle Hochspannungsdioden oder Hochspannungsgleichrichter D1, . . ., DN (Diodenkette). Im Falle der Verwendung eines nicht selbstöffnenden (selbstlöschenden) elektronischen Schalters, beispielsweise eine aus IGBT's, aus antiparallel geschalteten Thyristoren oder aus GTO-Thyristoren aufgebaute Schaltung, muß im gewünschten Öffnungszeitpunkt ein das Löschen verursachendes Steuersignal zugeführt werden.

Die im Ausführungsbeispiel für den Schalter U verwendeten Thyristoren sehen nach Beendigung des Umladevorganges vom Speicherkondensator C1 in die kapazitive Last C3 einen Stromnulldurchgang und beginnen den Stromfluß von selbst zu sperren, so daß die Diodenkette D1, . . . DN den Ladungsrückfluß übernehmen muß. Die Diodenkette D1, . . . DN verhindert damit gleichzeitig das Auftreten schädlicher negativer Spannungsimpulse am Schalter U, indem sie diese auf die der Durchlaßspannung der Diodenkette D1, . . . DN entsprechenden Werte begrenzt.

Der Entladevorgang des Speicherkondensators C1 ist somit auf die Zeitdauer einer halben Schwingungsperiode des Serienschwingkreises begrenzt, um ein Schwingen des Serienschwingkreises zu verhindern. Werden nicht selbstöffnende sondern den Stromfluß bidirektional leitende Halbleiterventile für den steuerbaren Schalter U verwendet, so kann der Entladevorgang des Speicherkondensators C1 auch auf eine Zeitdauer begrenzt werden, die kleiner ist als die Halbperiode der Schwingung. Außerdem kann ein aus solchen Halbleiterventilen aufgebauter Schalter U durch entsprechende Steuerung (Schließen) der Halbleiterventile in der folgenden Halbperiode auch den Strom beim Entladen der kapazitiven Last C3 oder allgemein beim Abbau der Spannung über der Last führen, so daß ein parallelgeschalteter Gleichrichter nicht erforderlich ist. Der Vorteil in der Verwendung einer Kombination aus einer Thyristorschaltung mit einem Gleichrichter liegt somit im wesentlichen in der Einfachheit der hierzu erforderlichen Steuerelektronik, da außer einem Zündimpuls für den Beginn des Entladevorgangs keine weiteren Steuersignale benötigt werden.

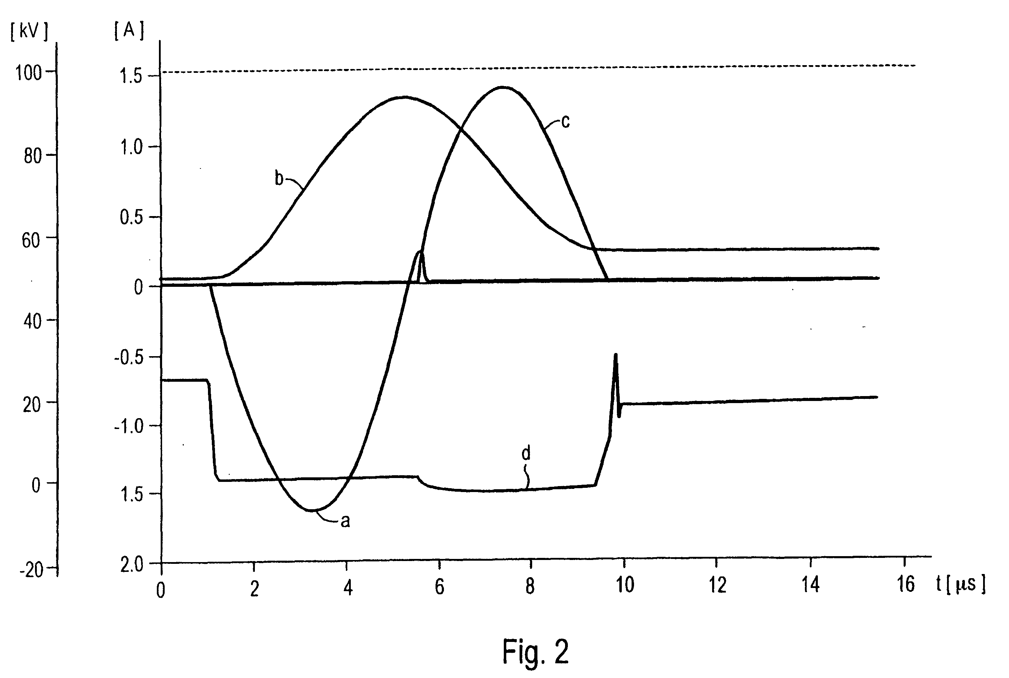

FIG 2 veranschaulicht die Funktionsweise des Pulsgenerators anhand der auftretenden Strom- und Spannungssignale. Nach Schließen des Schalters U beginnt ein Strom I(Schalter- oder Ladestrom I1) durch den Schalter U zu fließen ("switch current", Kurve a). Gleichzeitig steigt die Spannung an der kapazitiven Last C3 an ("filter voltage", Kurve b) und erreicht nach ca. 4 us ein Maximum von etwa 43 kV über der anliegenden Grundspannung von 50 kV, d.h. eine gesamte Spannung von 93 kV. Ab dem Zeitpunkt des Stromnulldurchganges im Schalter U beginnt der Schalter U zu sperren, und der Schalterstrom I1 (Ladestrom) geht auf Null zurück. In Gegenrichtung werden jedoch die Dioden der Diodenkette D1, . . ., DN leitfähig und führen die Ladung von der kapazitiven Last C3 zum Speicherkondensator C1 zurück ("diode current", Kurve c). Der Strom I fließt somit als Entlade- oder Diodenstrom I2 in die dem Ladestrom I1 entgegengesetzte Richtung. Dementsprechend sinkt auch die Spannung über der kapazitiven Last C3 wieder rasch auf etwa die Grundspannung zurück. Es resultiert somit ein Spannungspuls am Staubabscheider F von etwa 43 kV Amplitude und etwa 4,5 us Halbwertsbreite. Im Diagramm ist außerdem noch der Spannungsabfall über dem Schalter U eingetragen ("switch voltage", Kurve d). Dieser ist bei insgesamt geschlossenem Schalter U praktisch gleich Null und sinkt bei geöffnetem Schalter U auf einen negativen Wert, der der Durchlaßspannung der Diodenkette D1,...,DN entspricht.

Durch geeignete Wahl der passiven Komponenten, insbesondere von C1, C2, L2 und L4, kann die Pulsdauer in weiten Grenzen von etwa 1 µs bis zu einigen 10 µs variiert werden. Die Wahl von C1 im Verhältnis zu C3 bestimmt sowohl das Verhältnis von Pulsamplitude zu Ladespannung von C1, als auch die in C1 gespeicherte Energie. Bei dem gewählten Verhältnis von C1/C3 = 10 erhält man ein Verhältnis von U_{C3}/U_{C1} = 1,72 unter Berücksichtigung der Dämpfung durch Verluste in R2. (Ohne Dämpfung wäre ein Wert von 1,82 zu erwarten.)

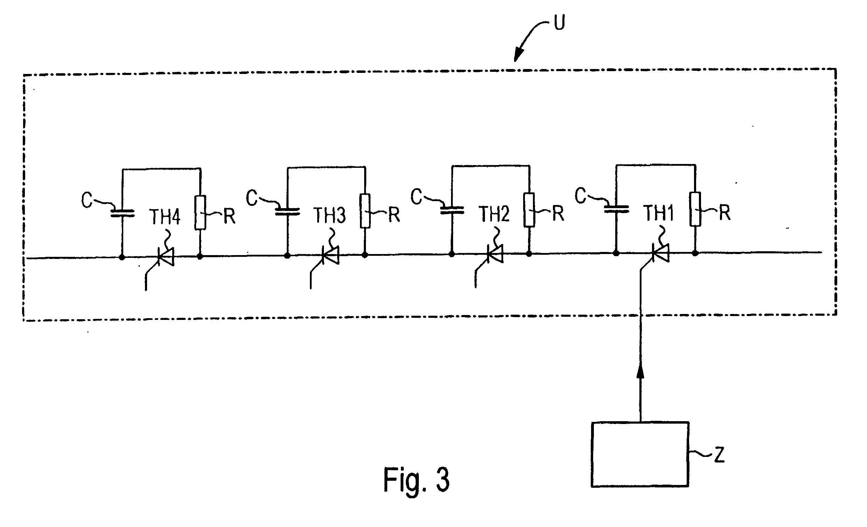

Die gewählte Form der Spannungsverdopplungsschaltung ermöglicht die Erzeugung von Hochspannungsimpulsen mit Amplituden von ca. 40 kV bei zu schaltenden Spannungen von nur etwa 25 kV. Dadurch können für den Schalter U hochspannungsfeste Thyristoren eingesetzt werden. Bei Verwendung von beispielsweise lichtzündbaren Thyristoren TH1,..,TH4 mit einer Sperrspannung von mehr als 7 kV (z. B. EUPEC Typ T1503N75T, [4]) wird gemäß FIG 3 bereits mit einer Stapelgröße von nur 4 in Serie geschalteten Thyristoren TH1,..,TH4 eine ausreichende Gesamtsperrspannung des Schalters U erreicht, ohne daß die Stromanstiegsrate dieser Thyristoren TH1,..,TH4 von maximal 2 kA/us überschritten wird. Durch die Lichtzündbarkeit ist außerdem eine potentialfreie Ansteuerung über Lichtwellenleiter möglich, so daß der Schaltungsaufwand für die Triggerung der Thyristoren TH1,..,TH4 erheblich verringert und das Betriebsverhalten wesentlich sicherer ist als bei einer elektrischen Triggerung mehrerer in Serie geschalteter Thyristoren TH1,..,TH4.

Eine besonders vorteilhafte Vereinfachung der Steuerung erhält man, wenn man die sogenannte Über-Kopf-Triggerbarkeit der lichtzündbaren Thyristoren TH1,..,TH4 ausnutzt. In diesem Falle muß nur noch ein einziger der in Serie geschalteten Thyristoren TH1,..,TH4, beispielsweise der Thyristor TH1 mit Hilfe einer Zündsteuerung Z, getriggert werden. Zündet dieser Thyristor TH1 durch, so teilt sich die am Thyristorstapel TH1,..,TH4 anstehende Spannung über die restlichen, noch sperrenden Thyristoren TH2,..,TH4 auf. Sobald die Spannung an diesen restlichen Thyristoren TH2,..,TH4 die jeweilige ÜberKopf-Spannungsfestigkeit des einzelnen Thyristors TH2,..,TH4 überschreitet, zündet dieser Thyristor TH2,..,TH4 auch ohne Triggerung durch, so daß innerhalb kurzer Zeit der gesamte Thyristorstapel TH1,..,TH4 durchzündet und den Impulserzeugungsvorgang einleitet.

Jedem Thyristor TH1,..,TH4 ist außerdem eine Schutzbeschaltung gegen hochfrequente Spannungsspitzen zugeordnet, die aus den Kondensatoren C und den Widerständen R besteht. In einer besonders vorteilhaften Schaltung werden für die Widerstände R Metalloxid-Varistoren eingesetzt, die die Thyristoren TH1, ...,TH4 vor unzulässigen Überspannungen schützen.

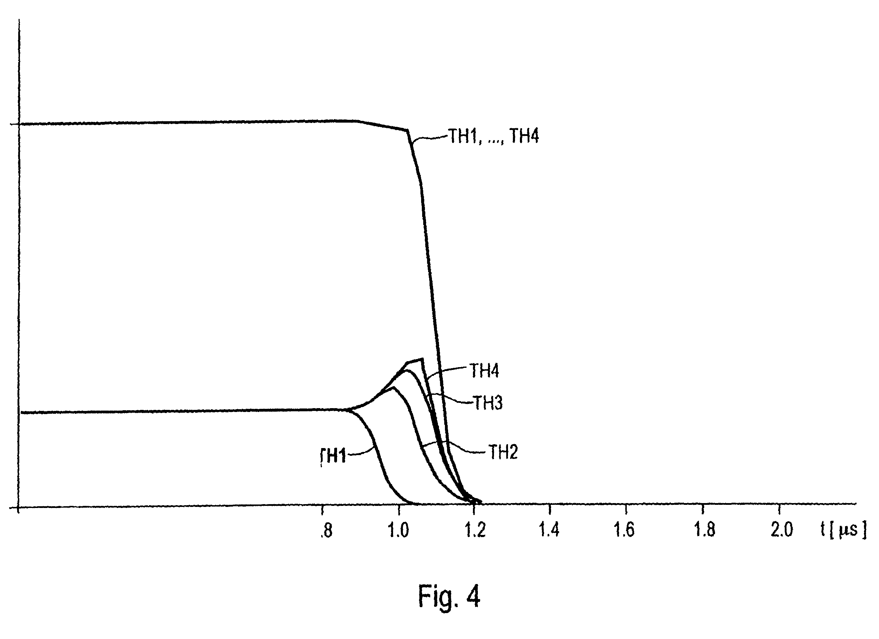

FIG 4 zeigt das Schaltverhalten eines solchen Thyristorstapels TH1,..,TH4, bei dem der erste Thyristor TH1 ("triggered thyristor", TH1) elektrisch oder optisch über Lichtleiter getriggert wird. Durch die an den weiteren Thyristoren TH2,..,TH4 ("overvolted thyristors", TH2,TH3,TH4) anstehenden Überspannungen zünden diese mit geringer Verzögerung durch, so daß am Ende die Gesamtspannung über dem Thyristorstapel TH1,..,TH4 ("total stack voltage", TH1,..,TH4) zusammenbricht. Zur Verdeutlichung wurde in diesem Beispiel angenommen, daß die Über-Kopf-gezündeten Thyristoren bei etwas unterschiedlichen Spannungen zünden.

Eine Erhöhung der Stromtragfähigkeit und der Stromanstiegsrate kann außerdem dadurch erreicht werden, daß die Thyristoren TH1,..,TH4 aus FIG 4 jeweils durch eine Thyristorschaltung ersetzt werden, die ihrerseits aus Parallelschaltung von zwei oder mehr Einzelthyristoren besteht.

Anstelle der Thyristoren TH2,...,TH4 können auch andere über-Kopf-zündbare Ventile, beispielsweise Dioden mit Lawinendurchbruchs-Kennlinie, eingesetzt werden.

Für manche Anwendungszwecke werden so hohe Spannungen, Ströme und Stromanstiegsraten gefordert, daß die zulässigen Paramecerbereiche der erhältlichen Thyristoren extrem überschritten werden. Eine Kombination aus Serien- und Parallelschaltung verfügbarer Einzelthyristoren ist in diesem Fall oft nicht wirtschaftlich und auch technisch nicht zuverlässig zu betreiben. In diesem Fall ist es vorteilhaft, die Schließfunktion des Teilschalters U2 gemäß FIG 5 durch einen Gasentladungsschalter G zu ersetzen, der die geforderten Parameter erfüllt. Die in Stromumkehrrichtung erforderliche Öffnungsfunktion des Schalters U1 wird in diesem Fall durch einen entsprechend dimensionierten in Reihe zu dem Gasentladungsschalter G geschalteten und analog zur Diodenkette D1,...,DN aufgebauten Gleichrichter D1',...,DN' erfüllt.

Da in der Phase, in der die Diodenkette D1',...,DN' den Strom trägt, der Gasentladungsschalter G stromlos ist, kann er bis zum Ende dieser Phase seine Spannungsfestigkeit wiedergewinnen und anschließend die am Speicherkondensator C1 wieder anstehende Hochspannung halten. Diese Schaltungsvariante ist möglich, da es technisch einfacher ist, hochspannungsfeste Halbleiterdioden mit kurzen Schaltzeiten und hoher Strombelastbarkeit zu fertigen, als dies bei Thyristoren möglich ist.

Für diese Variante besonders geeignete Schalter sind triggerbare Gasentladungsschalter mit Wasserstoffüllung, speziell im Niederdruckbereich, wie beispielsweise Thyratrons, Pseudofunkenschalter, Crossatrons, getriggerte Vakuumfunkenstrecken, und schnelle wasserstoffgefüllte Druckfunkenstrecken. Diesen Schaltern ist gemeinsam, daß sie eine besonders schnelle Wiederverfestigung bezüglich der Spannungsfestigkeit nach erfolgtem Schaltvorgang aufweisen; diese Eigenschaft ist notwendig, um sicherzustellen, daß während der kurzen Leitphase der Diodenkette D1,...,DN von typischerweise einigen Mikrosekunden Dauer der Schalter seine volle Spannungsfestigkeit wiedererlangt.

Die beschriebene Schaltung zur Impulsformung eignet sich besonders für den Einsatz bei stark oder vorwiegend kapazitiver Belastung. Durch entsprechende Wahl der Parameter der passiven Bauelemente ist eine Optimierung auch für induktive Lasten möglich. Besonders vorteilhaft ist dabei, daß sich die in der Last nicht verbrauchte elektrische Energie nahezu verlustfrei in den Speicherkondensator C1 zurückführen läßt bei vergleichsweise niedrigem Spannungsniveau und einer minimalen Anzahl an Bauelementen. Auf Widerstände und (stets verlustbehaftete) magnetische Schalter kann bei dieser Schaltung vollständig verzichtet werden, wodurch der Wirkungsgrad extrem hoch wird. Dadurch eignet sich diese Schaltung vor allem zur Erzeugung von Hochspannungsimpulsen mit hoher Pulswiederholrate, d.h. bei Anwendungen mit hoher mittlerer Gesamtleistung.

Bei der anhand der einzelnen Beispiele beschriebenen Erfindung kann im Kauf genommen werden, daß keine Halbleiterschaltelemente mit ausreichender Freiwerdezeit existieren. Durch die spezifische Kombination aus schnellem Schaltelement und parallelem schnellem Gleichrichter wird ermöglicht, daß sich das Schaltelement während der zweiten Stromhalbwelle erholen kann. Das Schaltelement wird also frei, da der Gleichrichter den Stromfluß übernimmt und somit das Schaltelement entlastet, womit hier die Freiwerdezeit definiert wird. Die gewünschte Funktion wird aber nur dann erreicht, wenn einerseits das Schaltelement eine Freiwerdezeit hat, die kleiner ist als die Dauer einer Stromhalbwelle, und anderer-seits der Gleichrichter eine Speicherladung hat, die klein ist im Vergleich zu der nach C3 transferierten Ladung.

## Patentansprüche

1. Pulsgenerator zum Erzeugen eines Spannungspulses für eine induktive oder kapazitive Last (C3) zur Verwendung bei einem elektrostatischen Staubabscheider (F), mit folgenden Merkmalen:
- ein selbstöffnender, steuerbarer Schalter (U1, U2), ein Speicherkondensator (C1), ein Hochspannungs-Entkopplungskondensator (C2) und Induktivitäten (L2, L4) sind in Reihe geschaltet und liegen parallel zur Last (C3),
- der Speicherkondensator (C1) ist erheblich größer als die Last (C3),
- eine Ladeschaltung (V1, L1, L3) für den Speicherkondensator (C1) ist parallel zum Schalter (U1, U2) und in Reihe mit dem Speicherkondensator (C1) und den Induktivitäten (L2, L4) geschaltet,
- eine Zusatzspannungsversorgung (V2) zum Anlegen eines Hochspannungspotentials am Staubabscheider ist vorgesehen,
- der Impulsgenerator und die Hochspannungsversorgung (V2) sind kapazitiv durch einen Kondensator (C2) getrennt.
- eine Freilaufschaltung aus Dioden (D1,...DN) liegt parallel zum Schalter (U1, U2).

2. Pulsgenerator nach Anspruch 1, **dadurch gekennzeichnet, daß** der Gleichrichter eine Halbleiterventilanordnung aus einer Mehrzahl von in Reihe geschalteten Dioden (D1, ..., DN) enthält.

3. Pulsgenerator nach einem der Ansprüche 1 bis 6, **dadurch gekennzeichnet, daß** der steuerbare Schalter (U) eine Thyristorschaltung enthält.

4. Pulsgenerator nach Anspruch 3, **dadurch gekennzeichnet, daß** in der Thyristorschaltung optisch zündbare Thyristoren (TH1, ..., TH4) vorgesehen sind.

5. Pulsgenerator nach Anspruch 3 oder 4, **dadurch gekennzeichnet, daß** die Thyristorschaltung eine Mehrzahl von in Reihe geschalteten Thyristoreinheiten enthält, wobei jede Thyristoreinheit aus einem einzelnen Thyristor (TH1, ..., TH4) oder einer Mehrzahl parallelgeschalteter Thyristoren aufgebaut ist.

6. Pulsgenerator nach Anspruch 5, **dadurch gekennzeichnet, daß** nur eine der in Reihe gegeschalteten Thyristoreinheiten an eine Zündsteuerung (Z) angeschlossen ist.

7. Pulsgenerator nach einem der Ansprüche 1 bis 6, **dadurch gekennzeichnet, daß** als steuerbarer Schalter (U) eine Reihenschaltung aus einem Gasentladungsschalter (G) und einem Gleichrichter (D1', ..., DN') vorgesehen ist.

8. Pulsgenerator nach einem der vorhergehenden Ansprüche, **dadurch gekennzeichnet, daß** der Speicherkondensator (C1) mindestens 10 mal so groß ist wie der Lastkondensator (C3).

9. Pulsgenerator nach einem der vorhergehenden Ansprüche, **dadurch gekennzeichnet, daß**
- ein transformatorloser Pulsgenerator gebildet ist,
- die Freiwerdezeit des Schalters (U) kleiner ist als die Stromflußdauer in einer Stromhalbwelle,
- ein parallel zum Schalter (U1, U2) geschalteter Gleichrichter (D1,...DN) zum Führen des zur Last (C3) in umgekehrter Richtung nach dem Nulldurchgang fließenden Stromes (I) vorhanden ist und
- die Speicherladung des Gleichrichters klein ist im Vergleich zur Ladung, die während der ersten Stromhalbwelle zur Last (C3) transferiert wird.

10. Pulsgenerator nach Anspruch 9, **dadurch gekennzeichnet, daß** die Durchlaßspannung des Gleichrichters kleiner ist als die Durchlaßspannung des Schalters (U).

11. verfahren zum Erzeugen eines Spannungspulses für eine induktive oder kapazitive Last (C3), unter Verwendung eines Pulsgenerators nach Anspruch 1 oder einem der Ansprüche 2 bis 10, bei der im Serienschwingkreis geschaltete Speicherkondensator (C1) durch Schließen und Öffnen des steuerbaren Schalters (U) in einem einmaligen Entladevorgang während nur einer halben Schwingungsperiode des Serienschwingkreises auf die Last (C3)entladen wird und bei dem zumindest ein Teil der beim Entladen des Speicherkondensators (C1) aus diesem abgeführten Ladung über den parallel zum Schalter (U) aus den Freilaufdioden (D1 ... D4) geschalteten Gleichrichter zurückgeführt wird.

12. Verfahren nach Anspruch 11, bei dem ein im Nulldurchgang des Stromes (I) selbstöffnender steuerbarer Schalter verwendet wird.

13. Verfahren nach Anspruch 11, bei der als Gleichrichter eine Mehrzahl von in Reihe geschalteten Dioden (D1, ..., DN) verwendet wird.

14. Verfahren nach einem der Ansprüche 11 bis 13, bei dem die Höhe des Spannungsimpulses über einer im wesentlichen kapazitiven Last (C3) durch Auswahl des Verhältnisses zwischen der Kapazität des Speicherkondensators (C1) und der Kapazität der Last (C3) eingestellt wird.

15. Verfahren nach einem der Ansprüche 11 bis 14, bei der als steuerbarer Schalter eine Thyristorschaltung verwendet wird.

16. Verfahren nach Anspruch 15, bei der zumindest ein Thyristor (TH1, ..., TH4) der Thyristorschaltung optisch gezündet wird.

17. Verfahren nach Anspruch 15 oder 16, bei der als Thyristorschaltung eine Mehrzahl von in Reihe geschalteten Thyristoreinheiten verwendet wird, wobei jede Thyristoreinheit aus einem einzelnen Thyristor (TH1, ..., TH4) oder einer Mehrzahl parallelgeschalteter Thyristoren aufgebaut ist.

18. Verfahren nach Anspruch 17, bei der nur eine der in Reihe geschalteten Thyristoreinheiten gezündet wird.

19. Verfahren nach einem der Ansprüche 11 bis 18, bei der als steuerbarer Schalter (U) ein in Reihe mit einem Gleichrichter (D1',...,DN') geschalteter Gasentladungsschalter (G) verwendet wird.

20. Verfahren nach einem der Ansprüche 11 bis 19, bei dem an die kapazitive Last (C3) eine Grundspannung (V2) gelegt wird.

## Claims

1. Pulse generator for producing a voltage pulse for an inductive or capacitive load (C3), in particular for an electrostatic dust extractor (F), having the following features:
- a self-opening, controllable switch (U1, U2), an energy-storage capacitor (C1), a high-voltage decoupling capacitor (C2) and inductances (L2, L4) are connected in series, and are connected in parallel with the load (C3),
- the energy-storage capacitor (C1) is considerably larger than the load (C3),
- a charging circuit (V1, L1, L3) for the energy-storage capacitor (C1) is connected in parallel with the switch (U1, U2) and in series with the energy-storage capacitor (C1) and the inductances (L2, L4),
- an additional voltage supply (V2) is provided for applying a high-voltage potential to the dust extractor,
- the pulse generator and the high-voltage supply (V2) are capacitively isolated by means of a capacitor (C2),
- a freewheeling circuit comprising diodes (D1, ... DN) is connected in parallel with the switch (U1, U2).

2. Pulse generator according to Claim 1, **characterized in that** the rectifier contains an active semiconductor arrangement comprising a number of series-connected diodes (D1, ..., DN).

3. Pulse generator according to one of Claims 1 to 6, **characterized in that** the controllable switch (U) contains a thyristor circuit.

4. Pulse generator according to Claim 3, **characterized in that** optically triggerable thyristors (TH1, ..., TH4) are provided in the thyristor circuit.

5. Pulse generator according to Claim 3 or 4, **characterized in that** the thyristor circuit contains a plurality of series-connected thyristor units, with each thyristor unit being formed from an individual thyristor (TH1, ..., TH4) or from a plurality of parallel-connected thyristors.

6. Pulse generator according to Claim 5, **characterized in that** only one of the series-connected thyristor units is connected to a trigger control (Z).

7. Pulse generator according to one of Claims 1 to 6, **characterized in that** a series circuit comprising a gas-discharge switch (G) and a rectifier (D1', ..., DN') is provided as the controllable switch (U).

8. Pulse generator according to one of the preceding claims, **characterized in that** the energy-storage capacitor (C1) is at least ten times as large as the load capacitor (C3).

9. Pulse generator according to one of the preceding claims, **characterized in that**:
- a pulse generator without a transformer is formed,
- the recovery time of the switch (U) is shorter than the period during which current flows in one current half-cycle,
- a rectifier (D1, ..., DN) which is connected in parallel with the switch (U1, U2) is provided to carry the current (I) which flows in the opposite direction to the load (C) after the zero crossing, and
- the energy-storage charge of the rectifier is small in comparison to the charge which is transferred to the load (C3) during the first current half-cycle.

10. Pulse generator according to Claim 9, **characterized in that** the forward voltage drop of the rectifier is less than the forward voltage drop of the switch (U).

11. Method for producing a voltage pulse for an inductive or capacitive load (C3) using a pulse generator according to Claim 1 or one of Claims 2 to 10, in which the energy-storage capacitor (C1) which is connected in the series tuned circuit is discharged to the load (C3) by closing and opening the controllable switch (U) in a single discharging process during only one half oscillation period of the series tuned circuit, and in which at least some of the charge which is dissipated from the energy-storage capacitor (C1) while it is being discharged can be fed back via the rectifier which is connected in parallel with the switch (U) and is formed from the freewheeling diodes (D1 ..., D4).

12. Method according to Claim 11, in which a controllable switch is used which is self-opening at the zero crossing of the current (I).

13. Method according to Claim 11, in which a number of series-connected diodes (D1, ..., DN) are used as the rectifier.

14. Method according to one of Claims 11 to 13, in which the magnitude of the voltage pulse across an essentially capacitive load (C3) is set by selection of the ratio of the capacitance of the energy-storage capacitor (C1) to the capacitance of the load (C3).

15. Method according to one of Claims 11 to 14, in which a thyristor circuit is used as the controllable switch.

16. Method according to Claim 15, in which at least one thyristor (TH1, ..., TH4) in the thyristor circuit is triggered optically.

17. Method according to Claim 15 or 16, in which a number of series-connected thyristor units are used as the thyristor circuit, with each thyristor unit being formed from an individual thyristor (TH1, ..., TH4) or from a number of parallel-connected thyristors.

18. Method according to Claim 17, in which only one of the series-connected thyristor units is triggered.

19. Method according to one of Claims 11 to 18, in which a gas-discharge switch (G) which is connected in series with a rectifier (DN', ..., DN') is used as the controllable switch (U).

20. Method according to one of Claims 1 to 19, in which a basic voltage (V2) is applied to the capacitive load (C3).

## Revendications

1. Générateur d'impulsion pour produire une impulsion de tension pour une charge (C3) inductive ou capacitive destiné à être utilisé dans un séparateur (F) électrostatique de poussière, ayant les caractéristiques suivantes :
- un interrupteur (U1, U2) s'ouvrant de soi-même et pouvant être commandé, un condensateur (C1) d'emmagasinage, un condensateur (C2) de découplage haute tension et des inductances (L2, L4) sont montés en série et sont en parallèle avec la charge (C3),
- le condensateur (C1) d'emmagasinage est considérablement plus grand que la charge (C3),
- un circuit (V1, L1, L3) de charge pour le condensateur (C1) d'emmagasinage est monté en parallèle avec l'interrupteur (U1, U2) et en série avec le condensateur (C1) d'emmagasinage et avec les inductances (L2, L4),
- il est prévu une alimentation (V2) supplémentaire en tension d'application d'un potentiel de haute tension au séparateur de poussière,
- le générateur d'impulsion et l'alimentation (V2) de haute tension sont séparés capacitivement par un condensateur (C2),
- un circuit de roue libre constitué de diodes (D1, ... DN) est monté en parallèle avec l'interrupteur (U1, U2).

2. Générateur d'impulsion suivant la revendication 1, **caractérisé en ce que** le redresseur de courant comprend un dispositif à soupape à semiconducteur constitué d'une multiplicité de diodes (D1, ... DN) montées en série.

3. Générateur d'impulsion suivant l'une des revendications 1 ou 2, **caractérisé en ce que** l'interrupteur (U) qui peut être commandé comporte un circuit à thyristor.

4. Générateur d'impulsions suivant la revendication 3, **caractérisé en ce qu'**il est prévu dans le circuit à thyristor des thyristors (TH1, ... TH4) pouvant être amorcés par voie optique.

5. Générateur d'impulsions suivant la revendication 3 ou 4, **caractérisé en ce que** le circuit à thyristor contient une multiplicité d'unités à thyristor montées en série, où chaque unité à thyristor est constituée d'un thyristor (TH1, ... TH4) unique ou d'une multiplicité de thyristors montés en parallèle.

6. Générateur d'impulsions suivant la revendication 5, **caractérisé en ce que** seule l'une des unités à thyristor montées en série est raccordée à une commande (Z) d'amorçage.

7. Générateur d'impulsions suivant l'une des revendications 1 à 6, **caractérisé en ce qu'**il est prévu comme interrupteur (U) pouvant être commandé un circuit série constitué d'un commutateur (G) à décharge dans un gaz et d'un redresseur (D1',..., DN').

8. Générateur d'impulsions suivant l'une des revendications précédentes, **caractérisé en ce que** le condenseur (C1) d'emmagasinage est au moins dix fois aussi grand que le condensateur (C3) de charge.

9. Générateur d'impulsions suivant l'une des revendications précédentes, **caractérisé en ce que**
- il est formé un générateur d'impulsions sans transformateur,
- le temps de recouvrement de l'interrupteur (U) est plus petit que la durée de passage du courant dans une demi-onde de courant,
- il est prévu un redresseur (D1, ..., DN) monté en parallèle à l'interrupteur (22) et destiné à faire passer le courant (I) allant à la charge (C3) en sens opposé après le passage par zéro, et
- la charge d'emmagasinage du redresseur est plus petite que la charge qui est transférée à la charge (C3) pendant la première demi-onde du courant.

10. Générateur d'impulsions suivant la revendication 9, **caractérisé en ce que** la tension de mise à l'état passant du redresseur est inférieure à la tension de mise à l'état passant de l'interrupteur (U).

11. Procédé de production d'une impulsion de tension pour une charge (C3) inductive ou capacitive en utilisant un générateur d'impulsion suivant la revendication 1 ou un générateur d'impulsion suivant l'une des revendications 2 à 10, dans lequel un condensateur (C1) d'emmagasinage monté dans le circuit oscillant série est déchargé sur la charge (C3) par fermeture et ouverture de l'interrupteur (U) qui peut être commandé dans une opération de décharge s'effectuant une seule fois pendant seulement une demi-période d'oscillation du circuit oscillant série et au moins une partie de la charge évacuée du condensateur (C1) d'emmagasinage lors de la décharge est retournée par le redresseur monté en parallèle avec l'interrupteur (U) à partir des diodes (D1, ..., D4) de roue libre.

12. Procédé suivant la revendication 11, dans lequel il est utilisé un interrupteur pouvant être commandé et s'ouvrant de soi-même au passage à zéro du courant (I).

13. Procédé suivant la revendication 11, dans lequel il est utilisé comme redresseur une multiplicité de diodes (D1, ..., DN) montées en série.

14. Procédé suivant l'une des revendications 11 à 13, dans lequel l'amplitude de l'impulsion de tension sur une charge (C3) sensiblement capacitive est réglée en choisissant le rapport entre la capacité du condensateur (C1) d'emmagasinage et la capacité de la charge (C3).

15. Procédé l'une des revendications 11 à 14, dans lequel il est utilisé un circuit à thyristor comme interrupteur pouvant être commandé.

16. Procédé suivant la revendication 15, dans lequel le au moins un thyristor (TH1, ..., TH4) du circuit à thyristor peut être amorcé par voie optique.

17. Procédé suivant la revendication 15 ou 16, dans lequel il est utilisé comme circuit à thyristor une multiplicité d'unités à thyristor montées en série, chaque unité à thyristor étant constituée d'un thyristor (TH1, ..., TH4) individuel ou d'une multiplicité de thyristors montés en parallèle.

18. Procédé suivant la revendication 17, dans lequel seul l'une des unités à thyristor montées en série est amorcée.

19. Procédé suivant l'une des revendications 11 à 18, dans lequel il est utilisé comme interrupteur (U) pouvant être commandé un interrupteur (G) à décharge dans un gaz monté en série avec un redresseur (D1', ..., DN').

20. Procédé suivant l'une des revendications 11 à 19, dans lequel il est appliqué une tension (V2) de base à la charge (C3) capacitive.
